# FASCICULE DE BREVET EUROPEEN

(11) **EP 0 624 921 B1**
(45) Date de publication et mention de la délivrance du brevet: **27.11.1996**
(21) Numéro de dépôt: 94400993.5
(22) Date de dépôt: 06.05.1994
(51) Int. Cl.: H01R 9/09, H01L 23/498

(54) **Dispositif de raccordement électrique et procédé de fabrication correspondant**
Elektrische Anschlussvorrichtung und zugehöriges Herstellungsverfahren
Electrical connection arrangement and associated process of manufacture

(30) Priorité: 14.05.1993 FR 9305818
(43) Date de publication de la demande: 17.11.1994
(73) Titulaire: PRONER COMATEL (Société Anonyme), 93161 Noisy-Le-Grand Cédex (FR)
(72) Inventeur: Raimond, Gérard, F-92120 Montrouge (FR)
(74) Mandataire: Laget, Jean-Loup

(56) Documents cités:
- EP-A- 0 307 766
- EP-A- 0 394 588
- FR-A- 2 302 006
- US-A- 5 090 926

## Description

L'invention est relative à un dispositif de raccordement électrique et à un procédé de fabrication correspondant.

Pour raccorder des composants électroniques, des circuits hybrides ou des circuits électroniques multicouches à une carte électronique principale, on utilise un montage selon lequel on implante à pas régulier, des pattes de raccordement ou "contacts" formant pinces de connexion et on soude ou on brase ensuite les parties formant pince de connexion de ces pattes de raccordement aux composants ou circuits précités.

De tels contacts, également appelés "lead frame" par les spécialistes anglo-saxons, se présentent généralement sous forme de bandes enroulées sur des bobines de diamètre important, aptes à être utilisées sur des machines automatiques d'insertion et de soudure de circuits imprimés, simultanément sur des bandes ou des portions de bandes de contacts.

Pour des raisons de fiabilité et de productivité, les dispositifs de raccordement électrique comportant des pattes de raccordement, ont évolué de manière à présenter à proximité de chaque pince de connexion, une quantité prédéterminée de matériau de brasure ou de soudure : ainsi, après avoir engagé les pinces de connexion sur le composant ou circuit correspondant, il suffit de faire fondre la quantité prédéterminée de matériau de brasure ou de soudure, pour que ce matériau s'écoule selon une configuration désirée et établisse en se refroidissant un raccordement électrique définitif.

Le document US 4.900.279 décrit un contact à souder ou à braser, comportant un élément de contact et un bras de contact relié à l'élément. Le bras comporte une base avec un contact central s'étendant au-dessus de la base et une couche de soudure sur la base. La couche de soudure comprend un faible revêtement situé au contact formant le point élevé du bras et présente une épaisseur qui augmente en s'éloignant du contact, pour fournir une masse de soudure ou de brasure apte à former une jonction avec le contact, lorsque le bras est chauffé.

Le contact peut également être prévu sous forme de pince élastique comportant deux bras de contact opposés l'un à l'autre.

Le document US 5.015.206 décrit un contact à souder ou à braser, comportant un élément de contact et un premier bras relié à l'élément. Le bras présente une base plane avec des bords opposés et une masse de soudure ou de brasure d'un seul tenant, comprenant un revêtement mince et plat de soudure entièrement relié à la base et une paire de réservoirs de soudure s'étendant le long des bords de la base et uniquement reliés au revêtement mince de soudure.

Ces dispositifs connus donnent satisfaction pour les espacements et pas d'implantation usuels, mais ne se prêtent pas à la miniaturisation et au resserrement du pas d'implantation pour les raisons suivantes :
. au moment de la fusion du matériau à souder ou à braser, le contact formant pince élastique du document US 4.900.279 est susceptible de glisser ou de se déplacer sur l'interface fondue du faible revêtement, situé au contact formant le point levé du bras ;
. au moment de la fusion du matériau à souder ou à braser, la pince élastique du document US 5.015.026 est susceptible de se déplacer sur le revêtement mince et plat de soudure. En outre, les réservoirs de soudure ne doivent être soumis à aucune vibration lorsqu'ils sont dans l'état liquide, de manière à éviter la formation de court-circuits non désirés.

L'invention a pour but de remédier aux inconvénients précités en créant un nouveau dispositif de raccordement, maintenant un serrage sensiblement constant de la partie formant pince et comportant une quantité de matériau de soudure positionnée de manière à ne pas provoquer de déplacement de la partie formant pince, lors de la fusion.

L'invention a pour objet un dispositif de raccordement électrique du type comportant une conformation repliée en matériau résilient, apte à assurer un maintien élastique et un revêtement en matériau malléable à souder ou à braser, destiné à être fondu pour assurer un raccordement électrique, caractérisé en ce que le revêtement en matériau malléable est placé sensiblement dans l'épaisseur du matériau résilient, en étant logé dans une rainure pratiquée dans l'épaisseur du matériau résilient.

Selon d'autres caractéristiques de l'invention :
- la rainure présente un fond plat et deux bords évasés ;
- au moins un des bords de la rainure est extérieur à la ligne d'appui élastique, de manière que le matériau malléable soit séparé de ladite ligne d'appui d'une distance prédéterminée ;
- le matériau malléable est replié et découpé avec le matériau résilient, de manière à ne pas déborder latéralement des organes de maintien élastique ;
- le dispositif se présente sous forme de bande, présentant une conformation en échelle avec des trous de guidage et de positionnement pour une insertion automatique de contacts électriques sur un côté d'un circuit hybride, d'un circuit imprimé ou analogue ;
- après insertion automatique, le matériau malléable est fondu, s'écoule par capillarité et se solidifie en formant des contacts électriques ne débordant pas sensiblement des organes de maintien élastique.

L'invention a également pour objet un procédé de fabrication de dispositif selon l'invention, comportant les étapes suivantes :
a) on pratique une rainure dans une bande de matériau résilient ;
b) on remplit entièrement ladite rainure de matériau malléable à braser ou à souder ;
c) on découpe la bande comportant la rainure remplie selon une conformation en échelle, munie de trous de positionnement ;
d) on effectue un pliage et un poinçonnement simultanés de la bande revêtue et découpée, pour constituer des organes de maintien élastique ;
e) on enroule la bande revêtue, découpée, pliée et poinçonnée sur une bobine de stockage.

L'invention a enfin pour objet un composant, circuit hybride ou un dispositif électronique équipé d'un dispositif de raccordement selon l'invention.

L'invention sera mieux comprise grâce à la description qui va suivre, donnée à titre d'exemple non limitatif, en référence aux dessins annexés dans lesquels :

La figure 1 représente schématiquement une première étape du procédé de fabrication selon l'invention.

La figure 2 représente schématiquement une deuxième étape du procédé de fabrication selon l'invention.

La figure 3 représente schématiquement en perspective partielle un dispositif selon l'invention en position d'insertion.

La figure 4 représente schématiquement en perspective partielle un montage définitif selon l'invention après soudage ou brasage.

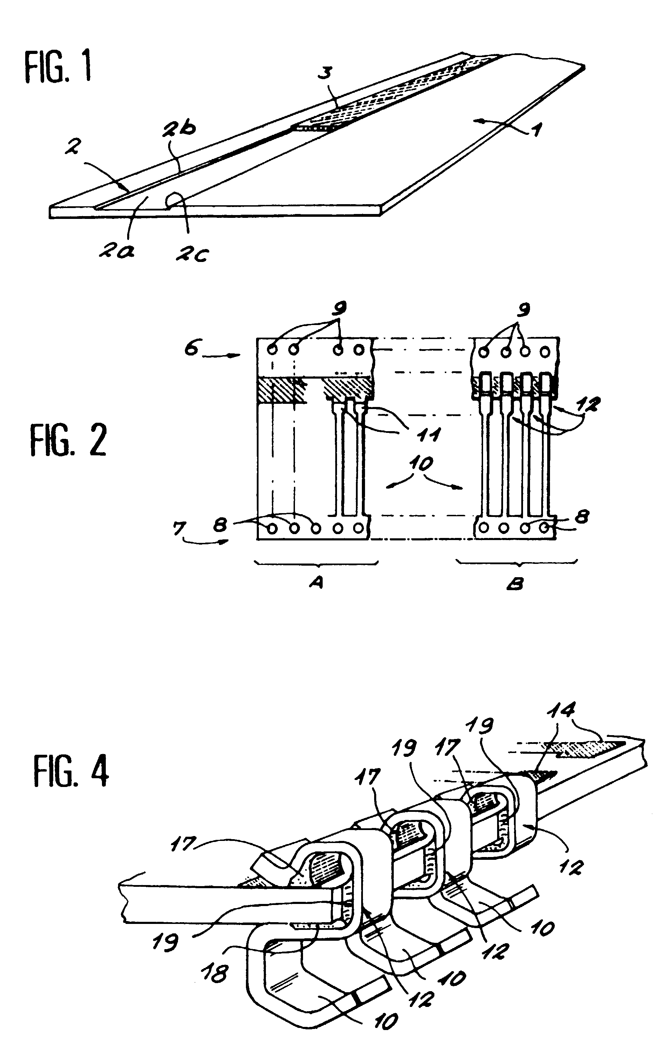

En référence à la figure 1, une bande 1 de métal résilient, tel que du bronze phosphoreux ou un alliage de caractéristiques élastiques et électriques similaires, est creusée de manière à présenter au moins une rainure 2.

La rainure 2 présente de préférence un fond plat 2a et deux bords évasés vers la haut 2b, 2c : la réalisation de la rainure est effectuée par enlèvement de matière, par exemple par pelage ou rabotage d'un copeau continu de matière ou par fraisage au moyen d'une fraise de forme adaptée.

Le canal délimité par la rainure 2 est rempli par un dépôt d'étain 3 à froid sous pression ou à chaud selon une quantité suffisante pour remplir entièrement ce canal : à cet effet, on prévoit par exemple une légère surépaisseur d'étain par rapport au plan de la bande 1. Cette surépaisseur est de préférence inférieure à 0,05 mm, de manière à assurer constamment un placage et une mise en compression de l'étain au cours des opérations de formage et de découpe ultérieures.

En effet, dans les opérations ultérieures de fabrication, on replie ensuite la bande 1, de manière que la bande 1 présente au voisinage du canal 2 des angles de pliage, une conformation en U ou une conformation polygonale telle que l'étain ou matériau ductile analogue soit mis en compression à l'intérieur d'un angle contre le fond duquel il est plaqué par la partie formant outil de pliage correspondante.

Dans cet exemple de réalisation, le matériau malléable et ductile de brasage ou de soudage est mentionné comme étant de l'étain pur : bien entendu, l'invention s'applique également à tout matériau ou alliage ductile analogue de brasage ou de soudage, tel qu'un alliage à 60% d'étain et à 40% de plomb, un alliage comportant de l'argent ou de l'or, etc...

En référence à la figure 2, on constitue par découpage et pliage dans une bande revêtue du type correspondant à la figure 1 une bande 4 de contacts 5.

A cet effet, on découpe au cours d'une première étape A la bande 1 de manière à constituer une conformation en forme d'échelle dont les bords 6, 7 sont percés de trous 8, 9 de guidage permettant l'insertion automatique de circuits hybrides par une machine de type connu.

Les barreaux 10 de cette conformation en échelle présentent une tête élargie 11 qui coïncide partiellement avec la partie découpée du canal 2, revêtu de matériau à braser ou à souder.

Au cours d'une deuxième étape B, on effectue simultanément un pliage et un poinçonnement de manière à constituer une conformation en pince 12 à l'intérieur de laquelle se trouve le matériau à souder ou à braser.

Cette conformation en pince 12 est adaptée pour être insérée sur le bord d'un circuit hybride, d'un composant destiné à être monté en surface ou analogue.

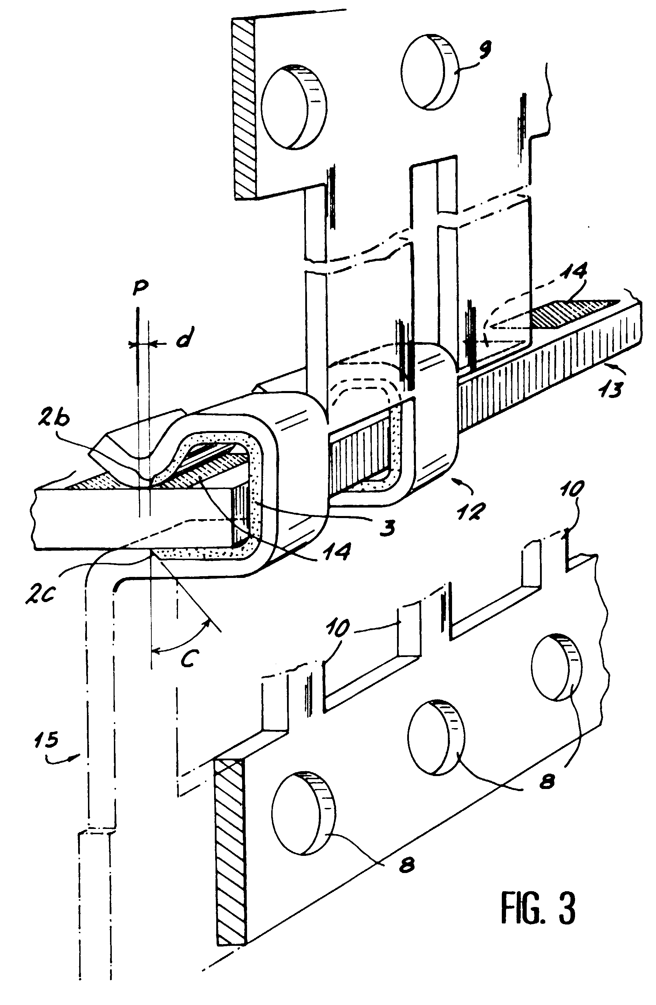

En référence à la figure 3, un circuit hybride 13 comportant des plots métallisés de connexion 14 et représenté avec une barrette 15 de contacts engagés par leurs pinces 12 sur les plots métallisés de connexion 14.

Les pinces 12 exercent sur les plots métallisés 14 une force de serrage sensiblement constante correspondant à l'ouverture élastique de la pince lors de l'insertion.

Le matériau malléable ou à braser 3 est en retrait du plan de pincement P correspondant à la ligne d'appui 16, d'une distance prédéterminée d : ainsi, lors de la fusion ultérieure du matériau 3, l'effet de pincement ne sera pas influencé par la liquéfaction du matériau 3.

En outre, les bords évasés 2b, 2c, limitant le logement 2 de matériau 3 sont inclinés d'un angle C compris entre 30 et 60 degrés d'angle par rapport au plan P dans un sens permettant d'éviter toute amorce de rupture ou fissuration lors de l'insertion des pinces 12 sur le composant 13 et permettant le maintien en compression sans fluage notable du matériau 3 à l'intérieur du canal 2 : ceci assure le parfait remplissage du canal 2 sans création de caverne ou de porosité génératrice de défaut de soudure ou brasure.

Le matériau 3 à souder ou à braser ne dépasse pas latéralement de la pince 12, avec laquelle il a été découpé et formé simultanément. Cette disposition évite tout court-circuit latéral non désiré, contrairement au court-circuit latéral, résultant de la présence de réservoirs de matériau dans les dispositifs de l'art antérieur.

En référence à la figure 4, après fusion du matériau 3, soudure et découpe finale des bandes de maintien comportant les orifices 8 et 9 de part et d'autre des pinces 12, on replie les pattes 10 selon une conformation adaptée au montage de composants en surface (CMS).

Le matériau 3 s'est écoulé lors de la fusion par capillarité et s'est solidifié dans une première position, correspondant à la formation d'un coin 17 formant contact avec le plot 14 intérieur à la pince 12 ; le coin 17 ne déborde pas latéralement de la pince 12.

La partie inférieure 18 de la conformation intérieure repliée du matériau est restée en place lors de la fusion et de la solidification, tandis que le matériau orienté verticalement est descendu par capillarité et est venu se solidifier en un bloc 19 de jonction ne débordant pas latéralement de la pince 12 correspondante.

L'invention décrite en référence à un mode de réalisation particulier couvre également toute modification de forme et variante de réalisation dans laquelle le matériau malléable à souder ou à braser est appliqué en compression à l'intérieur d'une conformation repliée, dans laquelle la conformation exerce un effet de maintien élastique analogue à l'effet d'une pince et dans laquelle la ligne d'appui mécanique ne comporte pas de revêtement intermédiaire de matériau malléable destiné à être fondu pour assurer le raccordement électrique par solidification ultérieure.

## Revendications

1. Dispositif de raccordement électrique du type comportant une conformation repliée en matériau résilient apte à assurer un maintien élastique et un revêtement en matériau malléable à souder ou à braser destiné à être fondu pour assurer un raccordement électrique, caractérisé en ce que le revêtement en matériau malléable (3) est placé sensiblement dans l'épaisseur du matériau résilient (1), en étant logé dans une rainure (2) pratiquée dans l'épaisseur du matériau résilient (1).

2. Dispositif selon la revendication 1, caractérisé en ce que la rainure (2) présente un fond plat (2a) et deux bords évasés (2b, 2c).

3. Dispositif selon la revendication 1 ou la revendication 2, caractérisé en ce qu'au moins un des bords (2b, 2c) de la rainure (2) est extérieur à la ligne d'appui (16) élastique, de manière que le matériau malléable (3) soit séparé de ladite ligne d'appui (16) d'une distance prédéterminée (d).

4. Dispositif selon l'une des revendications précédentes, caractérisé en ce que le matériau malléable (3) est replié et découpé avec le matériau résilient (1), de manière à ne pas déborder latéralement des organes (12) de maintien élastique.

5. Dispositif selon l'une des revendications précédentes, caractérisé en ce que le dispositif se présente sous forme de bande, présentant une conformation en échelle avec des trous (8, 9) de guidage et de positionnement pour une insertion automatique de contacts électriques sur un côté d'un circuit hybride, d'un circuit imprimé ou analogue.

6. Dispositif selon la revendication 5, caractérisé en ce qu'après insertion automatique, le matériau malléable (3) est fondu, s'écoule par capillarité et se solidifie en formant des contacts électriques (17, 19) ne débordant pas sensiblement des organes (12) de maintien élastique.

7. Procédé de fabrication d'un dispositif de raccordement électrique comportant les étapes suivantes :
a) on pratique une rainure (2) dans une bande (1) de matériau résilient ;
b) on remplit entièrement ladite rainure (2) de matériau malléable à braser ou à souder ;
c) on découpe la bande (1) comportant la rainure (2) remplie selon une conformation en échelle, munie de trous (8, 9) de positionnement.

8. Procédé selon la revendication 8, comportant en outre les étapes suivantes :
d) on effectue un pliage et un poinçonnement simultanés de la bande revêtue et découpée, pour constituer des organes (12) de maintien élastique ;
e) on enroule la bande revêtue, découpée, pliée et poinçonnée sur une bobine de stockage.

9. Composant ou circuit hybride comportant un montage par insertion, fusion et solidification d'un dispositif de raccordement électrique, selon l'une des revendications 1 à 6.

10. Dispositif électronique comportant un montage par insertion, fusion et solidification d'un dispositif de raccordement électrique selon l'une des revendications 1 à 6.

## Patentansprüche

1. Vorrichtung zum Herstellen einer elektrischen Verbindung mit einem gebogenen Element aus federndem Material zum elastischen Halten und einer Beschichtung aus einem verformbaren Material zum Löten oder Hartlöten, das geschmolzen wird, um eine elektrische Verbindung herzustellen, **dadurch gekennzeichnet,** daß die Beschichtung aus dem verformbaren Material (3) im wesentlichen innerhalb der Dicke des federndem Materials (1) angeordnet ist und sich in einer Nut (2), die innerhalb der Dicke des federnden Material (1) hergestellt ist, befindet.

2. Vorrichtung nach Anspruch 1, **dadurch gekennzeichnet,** daß die Nut (2) einen flachen Boden (2a) und zwei nach außen verlaufende Ränder (2b, 2c) aufweist.

3. Vorrichtung nach Anspruch 1 oder 2, **dadurch gekennzeichnet,** daß sich wenigstens einer der Ränder (2b, 2c) der Nut (2) außerhalb der elastischen Drucklinie (16) befindet, so daß das verformbare Material (3) von der Drucklinie (16) mit einer vorgebbaren Enffernung (d) beabstandet ist.

4. Vorrichtung nach einem der vorhergehenden Ansprüche, **dadurch gekennzeichnet,** daß das verformbare Material (3) zusammen mit dem federnden Material (1) derart gebogen und ausgestanzt ist, daß es nicht seitlich über die Klemmelemente (12) übersteht.

5. Vorrichtung nach einem der vorhergehenden Ansprüche, **dadurch gekennzeichnet,** daß sie als leiterartig ausgebildetes Band mit Führungs-und Positionierlöchern (8, 9) zum automatischen Einsetzen von elektrischen Kontakten auf einer Seite eines Hybridschaltkreises, eines gedruckten Schaltkreises oder dgl. vorliegt.

6. Vorrichtung nach Anspruch 5, **dadurch gekennzeichnet,** daß das verformbare Material (3) nach dem automatischen Einsetzen geschmolzen wird, durch Kapillarität fließt und sich unter Bildung von elektrischen Kontakten (17, 19), die im wesentlichen nicht über die Klemmelemente (12) hinrausragen, verfestigt.

7. Herstellungsverfahren für eine Vorrichtung zum Herstellen von elektrischen Verbindungen mit den folgenden Schritten:
a) es wird eine Nut (2) in einem Band (1) aus federndem Material hergestellt;
b) die Nut (2) wird vollständig mit einem verformbaren Hartlot oder Weichlot gefüllt;
c) das Band (1) mit der ausgefüllten Nut (2) wird leiterartig gestanzt und mit Positionierlöchern (8, 9) versehen.

8. Verfahren nach Anspruch 7, mit den zusätzlichen, folgenden Schritten:
d) das beschichtete und gestanzte Band wird gleichzeitig gebogen und ausgestanzt, um elastische Klemmelemente (12) zu bilden;
e) das beschichtete, gestanzte, gebogene und ausgestanzte Band wird auf eine Vorratstrommel gewickelt.

9. Komponente oder Hybridschaltkreis mit einer durch Einsetzen, Schmelzen und Verfestigen gebildeten Vorrichtung zum Herstellen einer elektrischen Verbindung entsprechend einem der Ansprüche 1 bis 6.

10. Elektronisches Bauteil mit einer durch Einsetzen, Schmelzen und Verfestigen einer gebildeten Vorrichtung zum Herstellen einer elektrischen Verbindung entsprechend einem der Ansprüche 1 bis 6.

## Claims

1. An electrical connection device of the type comprising a bent configuration made of resilient material capable of elastic holding and a coating of malleable soldering or brazing material to be melted in order to ensure an electrical connection, characterised in that the coating of malleable material (3) is placed substantially within the thickness of the resilient material (1), being lodged in a groove (2) made within the thickness of the resilient material (1).

2. A device according to Claim 1, characterised in that the groove (2) has a flat base (2a) and two splayed edges (2b, 2c).

3. A device according to Claim 1 or Claim 2, characterised in that at least one of the edges (2b, 2c) of the groove (2) is external to the elastic contact line (16), such that the malleable material (3) is separated from said contact line (16) by a given distance (d).

4. A device according to one of the preceding claims, characterised in that the malleable material (3) is bent and cut out with the resilient material (1) so as not to protrude laterally over the elastic holding elements (12).

5. A device according to one of the preceding claims, characterised in that the device is in the form of a strip, having a ladder-like configuration with holes (8, 9) for guiding and positioning for automatic insertion of electrical contacts on one side of a hybrid circuit, printed circuit or the like.

6. A device according to Claim 5, characterised in that after automatic insertion the malleable material (3) is melted, flows by capillary attraction and solidifies, forming electrical contacts (17, 19) which do not protrude substantially past the elastic holding elements (12).

7. A method for producing an electrical connection device, comprising the following steps:
a) a groove (2) is made in a strip (1) of resilient material;
b) said groove (2) is filled completely with malleable soldering or brazing material;
c) the strip (1) comprising the groove (2) filled in a ladder-like configuration, provided with three positioning holes (8, 9), is cut.

8. A method according to Claim 7, furthermore comprising the following stages:
d) simultaneous bending and punching of the coated, cut strip is effected, in order to form elastic holding elements (12);
e) the coated, cut, bent and punched strip is wound on a storage reel.

9. A component or hybrid circuit comprising mounting by insertion, melting and solidification of an electrical connection device according to one of Claims 1 to 6.

10. An electronic device comprising mounting by insertion, melting and solidification of an electrical connection device according to one of Claims 1 to 6.
